# EUROPEAN PATENT APPLICATION

(11) **EP 3 040 450 A1**
(43) Date of publication of application: **06.07.2016**
(21) Application number: 14839465.3
(22) Date of filing: 21.08.2014
(51) Int. Cl.: C25D 1/00, C25D 1/10, C25D 11/04, C25D 11/24

(54) **METHOD FOR MANUFACTURING METAL-FILLED MICROSTRUCTURE**

(30) Priority: 30.08.2013 JP 2013180005
(71) Applicant: Fujifilm Corporation, Minato-ku Tokyo 106-8620 (JP)
(72) Inventor: YAMASHITA Kosuke, Haibara-gun Shizuoka 421-0396 (JP)
(74) Representative: Hoffmann Eitle
(86) International application number: PCT/JP2014/071930
(87) International publication number: WO 2015/029881

(57) **Abstract**

An object of the present invention is to provide a method for manufacturing a metal-filled microstructure, capable of easily filling micropores with metal and suppressing the generation of residual stress caused by metal filling. A method for manufacturing a metal-filled microstructure according to the present invention includes: an anodic oxidation treatment step of anodically oxidizing a single surface of an aluminum substrate to form an anodic oxidation film on the single surface of the aluminum substrate, the anodic oxidation film including micropores, which are present in a thickness direction, and a barrier layer which is present in a bottom portion of the micropores; a barrier layer removal step of removing the barrier layer of the anodic oxidation film after the anodic oxidation treatment step; a metal filling step of filling the inside of the micropores with metal through an electroplating treatment after the barrier layer removal step; and a substrate removal step of removing the aluminum substrate to obtain a metal-filled microstructure after the metal filling step.

## Description

### BACKGROUND OF THE INVENTION

### 1. Field of the Invention

The present invention relates to a method for manufacturing a metal-filled microstructure.

### 2. Description of the Related Art

A metal-filled microstructure (device) obtained by filling micropores, which are provided on an insulating substrate, with metal is one of the fields which have attracted attention in recent nanotechnologies. For example, it is expected that the metal-filled microstructure will be used as an anisotropic conductive member.

An anisotropic conductive member is inserted between an electronic component such as a semiconductor element and a circuit substrate, and electric connection is obtained between the electronic component and the circuit substrate by simply applying pressure to the anisotropic conductive member. Therefore, an anisotropic conductive member is widely used, for example, as an electric connection member for an electronic component such as a semiconductor element or as a connector for inspection in a functional test.

As such an anisotropic conductive member, JP1992-126307A (H04-126307) describes "an anisotropic conductive film including: an insulating film member that is formed by oxidizing a conductive material by an anodic oxidation treatment; and plural conductive members, each of the plural conductive members being buried in the insulating film member and extending in a film thickness direction of the insulating film member" (claim 1). In addition, JP1992-126307A (H04-126307) describes "a method for manufacturing an anisotropic conductive film, the method including: a step of forming an anodic oxidation film having plural minute pores of a predetermined depth formed on an upper layer of a conductive substrate by an anodic oxidation treatment; a step of forming conductive members of metal in the pores of the anodic oxidation film by an electrolytic deposition process; a step of separating the anodic oxidation film from a lower layer of the conductive substrate; and a step of removing a surface layer of the anodic oxidation film to cause the conductive member to protrude from the anodic oxidation film (claim 6, Fig. 11).

In addition, JP2008-270158A describes "an anisotropic conductive member that is provided on an insulating substrate in a state in which plural conductive paths, which are formed of a conductive member and are insulated from each other, penetrate the insulating substrate in a thickness direction, one end of each of the conductive paths is exposed to one surface of the insulating substrate, and the other end of each of the conductive paths is exposed to the other surface of the insulating substrate. In this case, the density of the conductive paths is 2,000,000 pieces/mm² or more, and the insulating substrate is a structure that is formed of an anodic oxidation film of an aluminum substrate having micropores" (claim 1). Further, JP2008-270158A describes "a method of manufacturing an anisotropic conductive member, the method including: an anodic oxidation treatment step of anodically oxidizing an aluminum substrate; a penetration treatment step of forming through-holes from micropores, which are formed by the anodic oxidation treatment, to obtain the insulating substrate after the anodic oxidation treatment step; and a metal filling step of filling the inside of the through-holes in the insulating substrate with metal, which is a conductive member, to obtain the anisotropic conductive member after the penetration treatment step" (claim 5).

### SUMMARY OF THE INVENTION

The present inventors investigated the method of manufacturing an anisotropic conductive film (metal-filled microstructure) described in JP1992-126307A (H04-126307), and found that, when the lower layer of the conductive substrate is used as an electrode, the deposition of metal in the micropores of the anodic oxidation film is not likely to progress and the conductive member is not likely to be formed.

In addition, the present inventors investigated the method of manufacturing an anisotropic conductive member (metal-filled microstructure) described in JP2008-270158A, and found that warping or cracking may occur in the manufactured metal-filled microstructure due to residual stress generated by metal filling.

Therefore, an object of the present invention is to provide a method for manufacturing a metal-filled microstructure, capable of easily filling micropores with metal and suppressing the generation of residual stress caused by metal filling.

As a result of thorough study for achieving the above-described object, the present inventors found that micropores can be easily filled with metal and the generation of residual stress caused by metal filling can be suppressed by filling the inside of the micropores with metal before removing an aluminum substrate and after removing a barrier layer which is formed by an anodic oxidation treatment, thereby completing the present invention.

That is, the present invention provides a method for manufacturing a metal-filled microstructure having the following configuration.

[1] A method for manufacturing a metal-filled microstructure, the method including:
   an anodic oxidation treatment step of anodically oxidizing a single surface of an aluminum substrate to form an anodic oxidation film on the single surface of the aluminum substrate, the anodic oxidation film including micropores, which are present in a thickness direction, and a barrier layer which is present in a bottom portion of the micropores;
   a barrier layer removal step of removing the barrier layer of the anodic oxidation film after the anodic oxidation treatment step;
   a metal filling step of filling the inside of the micropores with metal through an electroplating treatment after the barrier layer removal step; and
   a substrate removal step of removing the aluminum substrate to obtain a metal-filled microstructure after the metal filling step.
[2] The method for manufacturing a metal-filled microstructure according to [1],
   in which in the barrier layer removal step, the barrier layer is electrochemically dissolved at a potential lower than that in the anodic oxidation treatment of the anodic oxidation treatment step.
[3] The method for manufacturing a metal-filled microstructure according to [1],
   in which in the barrier layer removal step, the barrier layer is removed by etching.
[4] The method for manufacturing a metal-filled microstructure according to [1],
   in which in the barrier layer removal step, the barrier layer is removed by etching after being electrochemically dissolved at a potential lower than that in the anodic oxidation treatment of the anodic oxidation treatment step.
[5] The method for manufacturing a metal-filled microstructure according to any one of [1] to [4], further including:
   a mask layer forming step of forming a mask layer having a desired shape in advance on a single surface of the aluminum substrate to be anodically oxidized before the anodic oxidation treatment step.
[6] The method for manufacturing a metal-filled microstructure according to any one of [1] to [5], further including:
   a film attachment step of attaching a peelable adhesive layer-attached film to a surface of the anodic oxidation film including the micropores filled with the metal before the substrate removal step and after the metal filling step; and
   a film peeling step of peeling off the adhesive layer-attached film after the substrate removal step.
[7] The method for manufacturing a metal-filled microstructure according to [5] or [6], further including:
   a polishing step of polishing a surface of the anodic oxidation film including the micropores filled with the metal and a surface of the mask layer to remove at least the mask layer after the metal filling step.
[8] The method for manufacturing a metal-filled microstructure according to any one of [1] to [7], further including:
   a surface smoothing step of smoothing the surface, in contact with the aluminum substrate, of the anodic oxidation film including the micropores filled with the metal after the substrate removal step.

According to the present invention, a method for manufacturing a metal-filled microstructure can be provided, capable of easily filling micropores with metal and suppressing the generation of residual stress caused by metal filling.

### BRIEF DESCRIPTION OF THE DRAWINGS

Figs. 1A to 1E are schematic cross-sectional views showing members before and after each treatment step in an example (first aspect) of a method for manufacturing a metal-filled microstructure according to the present invention.
Figs. 2A to 2F are schematic cross-sectional views showing members before and after each treatment step in another example (second aspect) of the method for manufacturing a metal-filled microstructure according to the present invention.
Figs. 3A to 3H are schematic cross-sectional views showing members before and after each treatment step in still another example (third aspect) of the method for manufacturing a metal-filled microstructure according to the present invention.
Figs. 4A to 4I are schematic cross-sectional views showing members before and after each treatment step in still another example (fourth aspect) of the method for manufacturing a metal-filled microstructure according to the present invention.
Figs. 5A to 5J are schematic cross-sectional views showing members before and after each treatment step in still another example (fifth aspect) of the method for manufacturing a metal-filled microstructure according to the present invention.
Figs. 6A to 6D are schematic cross-sectional views showing members before and after each treatment step in an example of a method for manufacturing a metal-filled microstructure according to Comparative Example 1.

### DESCRIPTION OF THE PREFERRED EMBODIMENTS

### [Method for Manufacturing Metal-Filled Microstructure]

A method for manufacturing a metal-filled microstructure according to the present invention (hereinafter, abbreviated as "manufacturing method according to the present invention") includes: an anodic oxidation treatment step of anodically oxidizing a single surface of an aluminum substrate to form an anodic oxidation film on the single surface of the aluminum substrate, the anodic oxidation film including micropores, which are present in a thickness direction, and a barrier layer which is present in a bottom portion of the micropores; a barrier layer removal step of removing the barrier layer of the anodic oxidation film after the anodic oxidation treatment step; a metal filling step of filling the inside of the micropores with metal through an electroplating treatment after the barrier layer removal step; and a substrate removal step of removing the aluminum substrate to obtain a metal-filled microstructure.

In the present invention, as described above, micropores can be easily filled with metal and the generation of residual stress caused by metal filling can be suppressed by filling the inside of the micropores with metal before removing an aluminum substrate and after removing a barrier layer which is formed by an anodic oxidation treatment.

The reason for this is not specifically clear but, approximately, is presumed to be as follows.

That is, the barrier layer which is present in the bottom portion of the micropores of the anodic oxidation film is removed. As a result, it is not necessary to remove the aluminum substrate, and the aluminum substrate can be used as an electrode when the inside of the aluminum substrate is filled with the metal. In addition, in a state where the anodic oxidation film is supported by the aluminum substrate, the inside of the micropores which are present in the aluminum substrate is filled with the metal. As a result, surprisingly, it is considered that the residual stress is relaxed.

The reason for this can be presumed from the result of a metal-filled microstructure according to Comparative Example 1 which exhibits a high residual stress value, the metal-filled microstructure being manufactured using the manufactured described in JP2008-270158A, that is, using a method in which metal filling is performed after removing an aluminum substrate to form through-holes derived from micropores. Likewise, the reason for this can be presumed from the result in which the residual stress is extremely low when the inside of micropores is filled with metal in a state where not only a lower portion of an anodic oxidation film but also the periphery of the anodic oxidation film are surrounded by an aluminum substrate by forming a mask layer before an anodic oxidation treatment.

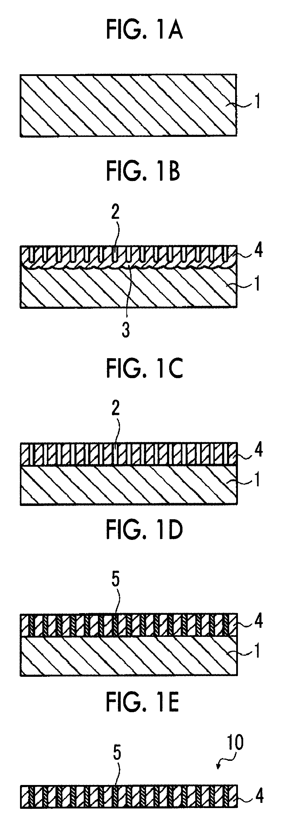

Next, the summary of each treatment step in the manufacturing method according to the present invention and the summary of each treatment step in a manufacturing method of the related art, for example, described in JP2008-270158A will be described using Figs. 1A to 5J and Figs. 6A to 6D, respectively. Next, the aluminum substrate used in the manufacturing method according to the present invention and each treatment step which is performed on the aluminum substrate will be described in detail.

### <First Aspect>

As shown in Figs. 1A to 1E, a metal-filled microstructure 10 can be manufactured using a manufacturing method including: an anodic oxidation treatment step (refer to Figs. 1 A and 1B) of anodically oxidizing a single surface of an aluminum substrate 1 to form an anodic oxidation film 4 on the single surface of the aluminum substrate 1, the anodic oxidation film 4 including micropores 2, which are present in a thickness direction, and a barrier layer 3 which is present in a bottom portion of the micropores 2; a barrier layer removal step (refer to Figs. 1B and 1C) of removing the barrier layer 3 of the anodic oxidation film 4 after the anodic oxidation treatment step; a metal filling step (refer to Figs. 1C and 1D) of filling the inside of the micropores 2 with metal 5 after the barrier layer removal step; and a substrate removal step (refer to Figs. 1D and 1E) of removing the aluminum substrate 1 after the metal filling step.

### <Second Aspect (Preferred Aspect)>

It is preferable that the manufacturing method according to the present invention includes a mask layer forming step described below.

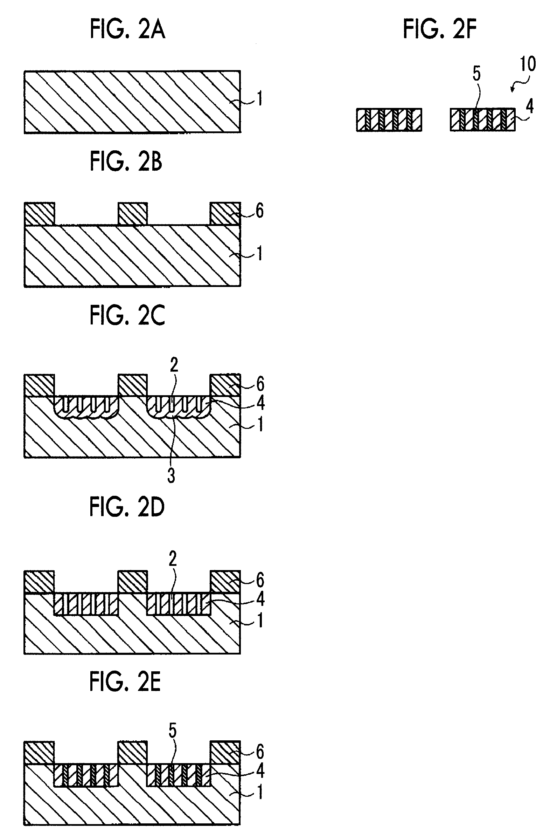

For example, as shown in Figs. 2A to 2F, the metal-filled microstructure 10 can be manufactured using a manufacturing method including: a mask layer forming step (refer to Figs. 2A and 2B) of forming a mask layer 6 having a desired shape in advance on a single surface of an aluminum substrate 1 to be anodically oxidized; an anodic oxidation treatment step (refer to Figs. 2B and 2C) of anodically oxidizing the surface of the aluminum substrate 1, where the mask layer 6 is formed, to form an anodic oxidation film 4 on the single surface of the aluminum substrate 1, the anodic oxidation film 4 including micropores 2, which are present in a thickness direction, and a barrier layer 3 which is present in a bottom portion of the micropores 2; a barrier layer removal step (refer to Figs. 2C and 2D) of removing the barrier layer 3 of the anodic oxidation film 4 after the anodic oxidation treatment step; a metal filling step (refer to Figs. 2D and 2E) of filling the inside of the micropores 2 with metal 5 after the barrier layer removal step; and a substrate removal step (refer to Figs. 2E and 2F) of removing the aluminum substrate 1 and the mask layer 6 after the metal filling step.

### <Third Aspect (Preferred Aspect)>

It is preferable that the manufacturing method according to the present invention includes a film attachment step and a film peeling step.

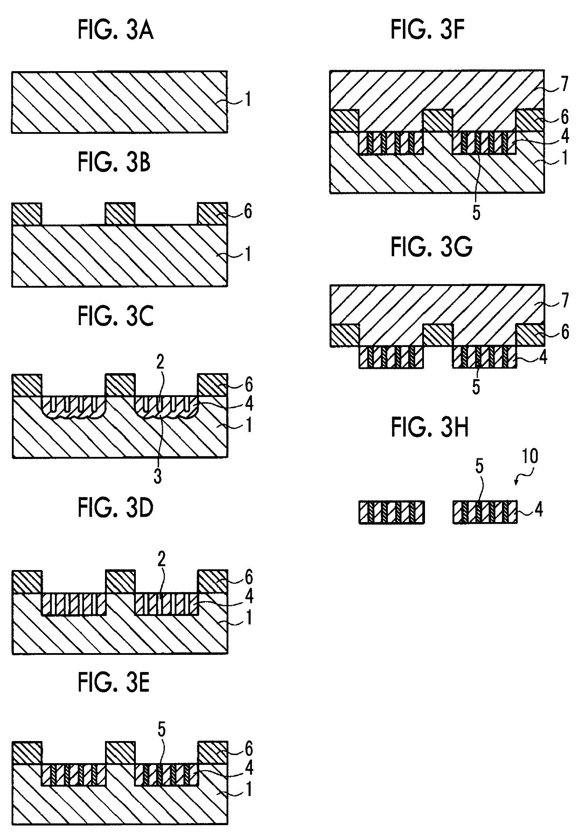

For example, as shown in Figs. 3A to 3H, the metal-filled microstructure 10 can be manufactured using a manufacturing method including: a mask layer forming step (refer to Figs. 3A and 3B) of forming a mask layer 6 having a desired shape in advance on a single surface of an aluminum substrate 1 to be anodically oxidized; an anodic oxidation treatment step (refer to Figs. 3B and 3C) of anodically oxidizing the surface of the aluminum substrate 1, where the mask layer 6 is formed, to form an anodic oxidation film 4 on the single surface of the aluminum substrate 1, the anodic oxidation film 4 including micropores 2, which are present in a thickness direction, and a barrier layer 3 which is present in a bottom portion of the micropores 2; a barrier layer removal step (refer to Figs. 3C and 3D) of removing the barrier layer 3 of the anodic oxidation film 4 after the anodic oxidation treatment step; a metal filling step (refer to Figs. 3D and 3E) of filling the inside of the micropores 2 with metal 5 after the barrier layer removal step; and a film attachment step (refer to Figs. 3E and 3F) of attaching a peelable adhesive layer-attached film 7 to a surface of the anodic oxidation film 4 including the micropores 2 filled with the metal 5 and a surface of the mask layer 6; a substrate removal step (refer to Figs. 3F and 3G) of removing the aluminum substrate 1 after the film attachment step; and a film peeling step (refer to Figs. 3G and 3H) of peeling off the adhesive layer-attached film 7 and the mask layer 6 after the substrate removal step.

### <Fourth Aspect (Preferred Aspect)>

It is preferable that the manufacturing method according to the present invention includes a polishing step described below.

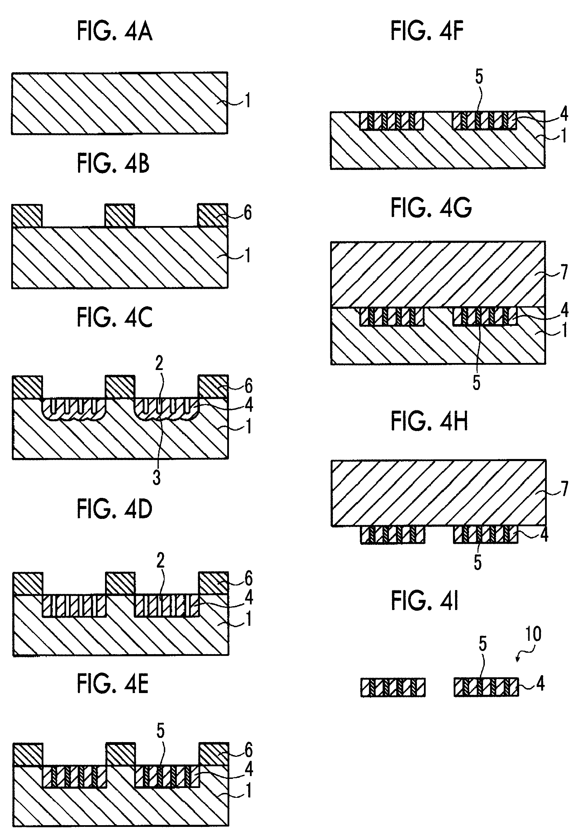

For example, as shown in Figs. 4A to 4I, the metal-filled microstructure 10 can be manufactured using a manufacturing method including: a mask layer forming step (refer to Figs. 4A and 4B) of forming a mask layer 6 having a desired shape in advance on a single surface of an aluminum substrate 1 to be anodically oxidized; an anodic oxidation treatment step (refer to Figs. 4B and 4C) of anodically oxidizing the surface of the aluminum substrate 1, where the mask layer 6 is formed, to form an anodic oxidation film 4 on the single surface of the aluminum substrate 1, the anodic oxidation film 4 including micropores 2, which are present in a thickness direction, and a barrier layer 3 which is present in a bottom portion of the micropores 2; a barrier layer removal step (refer to Figs. 4C and 4D) of removing the barrier layer 3 of the anodic oxidation film 4 after the anodic oxidation treatment step; a metal filling step (refer to Figs. 4D and 4E) of filling the inside of the micropores 2 with metal 5 after the barrier layer removal step; a polishing step (refer to Figs. 4E and 4F) of polishing a surface of the anodic oxidation film 4 including the micropores 2 filled with the metal 5 and a surface of the mask layer 6 to remove at least the mask layer 6; a film attachment step (refer to Figs. 4F and 4G) of attaching a peelable adhesive layer-attached film 7 to a surface of the anodic oxidation film 4 including the micropores 2 filled with the metal 5 and a surface of the aluminum substrate 1; a substrate removal step (refer to Figs. 4G and 4H) of removing the aluminum substrate 1 after the film attachment step; and a film peeling step (refer to Figs. 4H and 4I) of peeling off the adhesive layer-attached film 7 after the substrate removal step.

### <Fifth Aspect (Preferred Aspect)>

It is preferable that the manufacturing method according to the present invention includes a surface smoothing step described below.

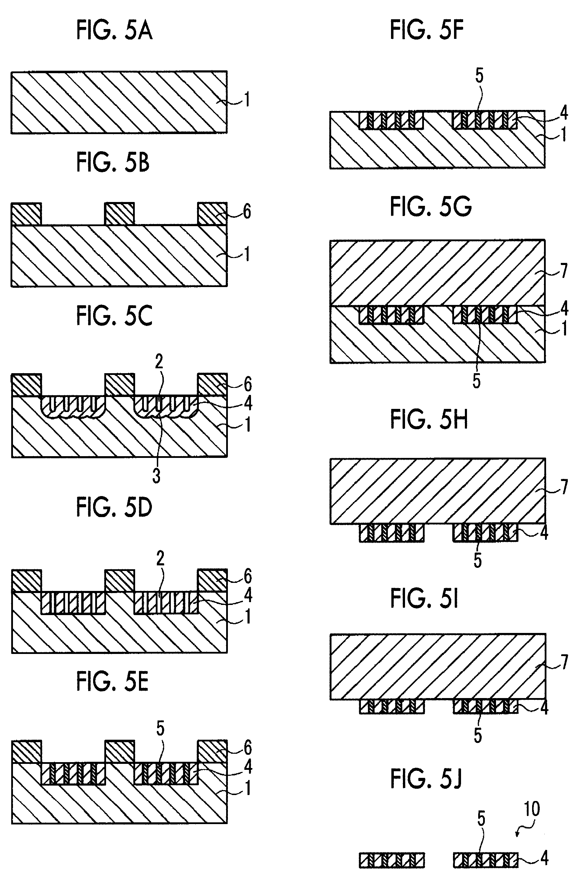

For example, as shown in Figs. 5A to 5J, the metal-filled microstructure 10 can be manufactured using a manufacturing method including: a mask layer forming step (refer to Figs. 5A and 5B) of forming a mask layer 6 having a desired shape in advance on a single surface of an aluminum substrate 1 to be anodically oxidized; an anodic oxidation treatment step (refer to Figs. 5B and 5C) of anodically oxidizing the surface of the aluminum substrate 1, where the mask layer 6 is formed, to form an anodic oxidation film 4 on the single surface of the aluminum substrate 1, the anodic oxidation film 4 including micropores 2, which are present in a thickness direction, and a barrier layer 3 which is present in a bottom portion of the micropores 2; a barrier layer removal step (refer to Figs. 5C and 5D) of removing the barrier layer 3 of the anodic oxidation film 4 after the anodic oxidation treatment step; a metal filling step (refer to Figs. 5D and 5E) of filling the inside of the micropores 2 with metal 5 after the barrier layer removal step; a polishing step (refer to Figs. 5E and 5F) of polishing a surface of the anodic oxidation film 4 including the micropores 2 filled with the metal 5 and a surface of the mask layer 6 to remove at least the mask layer 6; a film attachment step (refer to Figs. 5F and 5G) of attaching a peelable adhesive layer-attached film 7 to a surface of the anodic oxidation film 4 including the micropores 2 filled with the metal 5 and a surface of the aluminum substrate 1; a substrate removal step (refer to Figs. 5G and 5H) of removing the aluminum substrate 1 after the film attachment step; a surface smoothing step (refer to Figs. 5H and 5I) of smoothing the surface (in contact with the aluminum substrate 1) of the anodic oxidation film 4 including the micropores 2 filled with the metal 5 after the substrate removal step; and a film peeling step (refer to Figs. 5I and 5J) of peeling off the adhesive layer-attached film 7 after the surface smoothing step.

### <Aspect of Related Art>

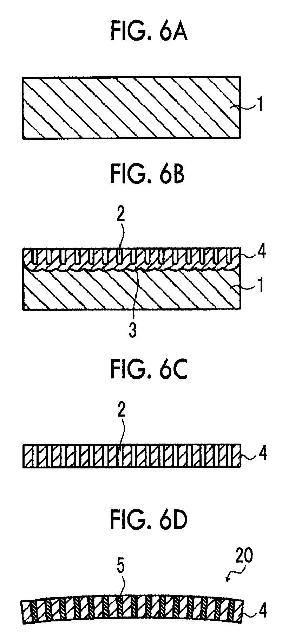

As shown in Figs. 6A to 6D, a metal-filled microstructure 20 can be manufactured using a manufacturing method of the related art including: an anodic oxidation treatment step (refer to Figs. 6A and 6B) of anodically oxidizing a single surface of an aluminum substrate 1 to form an anodic oxidation film 4 on the single surface of the aluminum substrate 1, the anodic oxidation film 4 including micropores 2, which are present in a thickness direction, and a barrier layer 3 which is present in a bottom portion of the micropores 2; a penetration step (Figs. 6B and 6C) of removing the aluminum substrate 1 and the barrier layer 3 to form through-holes from the micropores 2 (refer to Figs.6B and 6C); and a metal filling step (refer to Figs. 6C and 6D) of filling the inside of the micropores 2 with metal 5 after the penetration step.

### [Aluminum Substrate]

The aluminum substrate used in the manufacturing method according to the present invention is not particularly limited, and specific examples thereof include: a pure aluminum sheet; an alloy sheet containing aluminum as a major component and further containing a small amount of different element; a substrate in which high-purity aluminum is vapor-deposited on low-purity aluminum (for example, a recycling material); a substrate in which a surface of a silicon wafer, quartz, glass, or the like is coated with high-purity aluminum using a method such as vapor deposition or sputtering; a resin substrate in which aluminum is laminated.

In the present invention, on a surface of the aluminum substrate where the anodic oxidation film is provided in the anodic oxidation treatment step described below, the aluminum purity is preferably 99.5 mass% or higher, more preferably 99.9 mass% or higher, and still more preferably 99.99 mass% or higher. When the aluminum purity is within the above-described range, the regularity of micropore arrangement is sufficient.

In addition, in the present invention, it is preferable that a heat treatment, a degreasing treatment, and a mirror finishing treatment are performed in advance on a single surface of the aluminum substrate where the anodic oxidation treatment step described below is performed.

Here, regarding the heat treatment, the degreasing treatment, and the mirror finishing treatment, the same treatment as each treatment described in paragraphs "0044" to "0054" of JP2008-270158A can be performed.

### [Anodic Oxidation Treatment Step]

In the an anodic oxidation step, a single surface of the aluminum substrate is anodically oxidized to form an anodic oxidation film on the single surface of the aluminum substrate, the anodic oxidation film including micropores, which are present in a thickness direction, and a barrier layer which is present in a bottom portion of the micropores.

For the anodic oxidation treatment in the manufacturing method according to the present invention, a well-known method of the related art can be used, but it is preferable that a self-regulation method or a constant voltage treatment is used from the viewpoints of obtaining high regularity of micropore arrangement and securing the anisotropic conductivity of the metal-filled microstructure.

Here, regarding the self-regulation method or the constant voltage treatment for the anodic oxidation treatment, the same treatment as each treatment described in paragraphs "0056" to "0108" and Fig. 3 of JP2008-270158A can be performed.

### [Barrier Layer Removal Step]

In the barrier layer removal step, the barrier layer of the anodic oxidation film is removed after the anodic oxidation treatment step. By removing the barrier layer, as shown in Fig. 1C, a part of the aluminum substrate is exposed through the micropores 2.

A method of removing the barrier layer is not particularly limited, and examples thereof include a method of electrochemically dissolving the barrier layer at a potential lower than that in the anodic oxidation treatment of the anodic oxidation treatment step (hereinafter, also referred to as "electrolytic removal treatment"); a method of removing the barrier layer by etching (hereinafter, also referred to as "etching removal treatment"); and a combination of the above-described methods (in particular, a method of etching the barrier layer remaining after the electrolytic removal treatment).

### <Electrolytic Removal Treatment>

The electrolytic removal treatment is not particularly limited as long as it is an electrolytic treatment which is performed at a potential (electrolytic potential) lower than that in the anodic oxidation treatment of the anodic oxidation treatment step.

In the present invention, the electrolytic dissolution treatment can be continuously performed after the anodic oxidation treatment by decreasing the electrolytic potential at the time of completion of the anodic oxidation treatment step.

In the electrolytic removal treatment, regarding conditions other than the electrolytic potential, the same electrolytic solution and treatment conditions as in the above-described well-known anodic oxidation treatment of the related art can be adopted.

In particular, when the electrolytic removal treatment and the anodic oxidation treatment are continuously performed as described above, it is preferable that the same electrolytic solution is used during the treatments.

### (Electrolytic Potential)

It is preferable that the electrolytic potential in the electrolytic removal treatment is decreased continuously or stepwise at a potential lower than that in the anodic oxidation treatment.

Here, when the electrolytic potential is decreased stepwise, the decrease width (step width) is preferably 10 V or lower, more preferably 5 V or lower, and still more preferably 2 V or lower from the viewpoint of the withstand voltage of the barrier layer.

In addition, when the electrolytic potential is decreased continuously or stepwise, the voltage decrease rate is preferably 1 V/sec or lower, more preferably 0.5 V/sec or lower, and still more preferably 0.2 V/sec or lower from the viewpoints of productivity and the like.

### <Etching Removal Treatment>

The etching removal treatment is not particularly limited and may be a chemical etching treatment in which the battery layer is dissolved using an acid aqueous solution or an alkali aqueous solution or may be a dry etching treatment.

### (Chemical Etching Treatment)

During the removal of the barrier layer through the chemical etching treatment, for example, only the barrier layer can be selectively dissolved by bringing a surface of the anodic oxidation film on a micropore-opening side into contact with a pH buffer solution after dipping the structure having undergone the anodic oxidation treatment step in an acid aqueous solution or an alkali aqueous solution such that the inside of the micropores is filled with the acid aqueous solution and the alkali aqueous solution.

Here, when the acid aqueous solution is used, it is preferable that an inorganic acid such as sulfuric acid, phosphoric acid, nitric acid, hydrochloric acid, or oxalic acid or an aqueous solution of a mixture of the above inorganic acids is used. In addition, the concentration of the acid aqueous solution is preferably 1 mass% to 10 mass%. The temperature of the acid aqueous solution is preferably 15°C to 80°C, more preferably 20°C to 60°C, and still more preferably 30°C to 50°C.

On the other hand, when the alkali aqueous solution is used, it is preferable that an aqueous solution of at least one alkali selected from the group consisting of sodium hydroxide, potassium hydroxide, and lithium oxide is used. In addition, the concentration of the alkali aqueous solution is preferably 0.1 mass% to 5 mass%. The temperature of the alkali aqueous solution is preferably 10°C to 60°C, more preferably 15°C to 45°C, and still more preferably 20°C to 35°C.

Specifically, for example, it is preferable that a phosphoric acid aqueous solution of 50 g/L and 40°C, a sodium hydroxide aqueous solution of 0.5 g/L and 30°C, or a potassium hydroxide aqueous solution of 0.5 g/L and 30°C is used.

As the pH buffer solution, a buffer solution corresponding to the acid aqueous solution or the alkali aqueous solution can be appropriately used.

In addition, the time of dipping in the acid aqueous solution or the alkali aqueous solution is preferably 5 minutes to 120 minutes, more preferably 8 minutes to 120 minutes, still more preferably 8 minutes to 90 minutes, and even still more preferably 10 minutes to 90 minutes. In particular, the time of dipping is preferably 10 minutes to 60 minutes and more preferably 15 minutes to 60 minutes.

### (Dry Etching Treatment)

In the dry etching treatment, for example, it is preferable that a gas species such as Cl₂/Ar mixed gas is used.

### [Metal Filling Step]

In the metal filling step, the inside of the micropores in the anodic oxidation film is filled with metal through an electroplating treatment after the barrier layer removal step.

### <Metal>

It is preferable that the metal is a material having an electrical resistivity of 10³ Ω·cm or lower, and preferable specific examples thereof include gold (Au), silver (Ag), copper (Cu), aluminum (Al), magnesium (Mg), nickel (Ni), and tin oxide doped with indium (ITO).

Among these, from the viewpoint of electrical conductivity, copper, gold, aluminum, or nickel is preferable and copper or gold is more preferable.

### <Filling Method>

Examples of a method of filling the inside of the micropores with the metal include the same method as each method described in paragraphs "0123" to "0126" and Fig. 4 of JP2008-270158A.

In the present invention, the barrier layer is removed in the barrier layer removal step. Therefore, unlike JP2008-270158A, the aluminum substrate can be used as an electrode (film).

Therefore, in the present invention, as described above, the micropores can be easily filled with metal, and the generation of residual stress caused by metal filling can be suppressed.

### [Substrate Removal Step]

In the substrate removal step, the aluminum substrate is removed to obtain a metal-filled microstructure after the metal filling step.

A method of removing the aluminum substrate is not particularly limited. For example, a method of removing the aluminum substrate by dissolving is preferably used.

### <Dissolution of Aluminum Substrate>

During the dissolution of the aluminum substrate, a treatment liquid in which the anodic oxidation film is not easily dissolved and aluminum is easily dissolved is preferably used.

The dissolution rate of aluminum in the treatment liquid is preferably 1 µm/min or higher, more preferably 3 µm/min or higher, and still more preferably 5 µm or higher. Likewise, the dissolution rate of the anodic oxidation film in the treatment liquid is preferably 0.1 nm/min or lower, more preferably 0.05 nm/min or lower, and still more preferably 0.01 nm/min or lower.

Specifically, it is preferable that the treatment liquid contains at least one metal compound having lower ionization tendency than aluminum and has pH of 4 or lower or 8 or higher. The pH is more preferably 3 or lower or 9 or higher and 2 or lower or 10 or higher.

It is preferable that the treatment liquid is obtained by blending the acid or alkali aqueous solution as a base with, for example, manganese, zinc, chromium, iron, cadmium, cobalt, nickel, tin, lead, antimony, bismuth, copper, mercury, silver, palladium, platinum, a gold compound (for example, chloroplatinic acid), a fluoride thereof, or a chloride thereof.

Among these, it is preferable that the acid aqueous solution as a base is blended with a chloride.

In particular, a treatment liquid (hydrochloric acid/mercury chloride) obtained by blending mercury chloride with the hydrochloric acid aqueous solution or a treatment liquid (hydrochloric acid/copper chloride) obtained by blending copper chloride with the hydrochloric acid aqueous solution is preferable from the viewpoint of treatment latitude.

The composition of the treatment liquid is not particularly limited. For example, a bromine-methanol mixture, a bromine-ethanol mixture, or aqua regia can be used.

In addition, the concentration of the acid or alkali in the treatment liquid is preferably 0.01 mol/L to 10 mol/L and more preferably 0.05 mol/L to 5 mol/L.

Further, the treatment temperature in the treatment liquid is preferably -10°C to 80°C and more preferably 0°C to 60°C.

In addition, the dissolution of the aluminum substrate is performed by bringing the aluminum substrate after the metal filling step into contact with the above-described treatment liquid. A dipping method is not particularly limited, and examples thereof include a dip coating method and a spray coating method. Among these, a dip coating method is preferable. At this time, the contact time is preferably 10 seconds to 5 hours and more preferably 1 minute to 3 hours.

### [Mask Layer Forming Step]

The mask layer forming step is an arbitrary step of forming a mask layer having a desired shape in advance on a single surface of the aluminum substrate to be anodically oxidized before the anodic oxidation treatment step.

By the manufacturing method including the mask layer forming step, the generation of residual stress by the metal filling of the manufactured metal-filled microstructure can be suppressed. As described above, the reason for this can be presumed to be as follows: the inside of the micropores can be filled with metal in a state where not only the lower portion of the anodic oxidation film but also the periphery of the anodic oxidation film are surrounded by the aluminum substrate.

Therefore, in the present invention, a metal-filled microstructure having low residual stress and a large area can be prepared. Therefore, it is preferable that the mask layer is provided at an end portion on a single surface of the aluminum substrate.

The mask layer can be formed, for example, using a method including: forming an image recording layer on the surface of the aluminum substrate; and developing a predetermined opening pattern by exposing or heating the image recording layer to apply energy thereto.

Here, a material for forming the image recording layer is not particularly limited. For example, a material for forming a photosensitive layer (photoresist layer) or a heat-sensitive layer of the related art can be used and, optionally, contains an additive such as an infrared absorber.

### [Film Attachment Step]

The film attachment step is an arbitrary step of attaching a peelable adhesive layer-attached film to a surface of the anodic oxidation film including the micropores filled with the metal (when the manufacturing method includes the mask layer forming step, "the anodic oxidation film and the mask layer"; when the manufacturing method includes the polishing step described below, "the anodic oxidation film and the aluminum substrate") before the substrate removal step and after the metal filling step.

The manufacturing method optionally includes the film attachment step and the film peeling step described below. In this case, when the manufacturing method includes the mask layer forming step, a metal-filled microstructure manufactured by dicing can be primarily held, and handleability is improved (for example, refer to Fig. 3G and Fig. 4H).

The adhesive layer-attached film is not particularly limited, and it is preferable that an easily peelable adhesive layer-attached film is used.

In the present invention, as the adhesive layer-attached film, for example, a commercially available product having the following series names can be used: SUNYTECT (registered trade name; manufactured by Sun A. Kaken Co., Ltd.) obtained by forming an adhesive layer on a surface of a polyethylene resin film; E-MASK (registered trade name; manufactured by Nitto Denko Corporation) obtained by forming an adhesive layer on a surface of a polyethylene terephthalate resin film; and MASTAC (registered trade name; manufactured by Fujimori Kogyo Co., Ltd.) obtained by forming an adhesive layer on a surface of a polyethylene terephthalate resin film.

In addition, a method of attaching the adhesive layer-attached film is not particularly limited. For example, the attachment can be performed using a device for attaching a surface protective tape or a laminator which is well-known in the related art.

### [Film Peeling Step]

The film peeling step is an arbitrary step of peeling off the adhesive layer-attached film after the film attachment step and the substrate removal step or, when the manufacturing method includes the mask layer forming step and does not include the polishing step described below, is an arbitrary step of peeling off the mask layer in addition to the adhesive layer-attached film.

Here, a method of peeling off the adhesive layer-attached film is not particularly limited. For example, the peeling can be performed using a device for peeling off a surface protective tape of the related art.

### [Polishing Step]

The polishing step is an arbitrary step of polishing a surface of the anodic oxidation film including the micropores filled with the metal and a surface of the mask layer to remove at least the mask layer after the metal filling step (when the manufacturing method includes the film attachment step, before the film attachment step).

By the manufacturing method including the polishing step, the adhesive layer-attached film is easily attached in the film attachment step, and the remaining metal attached to the surface of the anodic oxidation film after filling the micropores with the metal can be removed.

In addition, examples of a polishing method in the polishing step include various treatment methods used in the surface smoothing step described below.

### [Surface Smoothing Step]

The surface smoothing step is an arbitrary step of smoothing the surface, in contact with the aluminum substrate, of the anodic oxidation film including the micropores filled with the metal after the substrate removal step (when the manufacturing method includes the film peeling step, before the film peeling step).

By the manufacturing method including the surface smoothing step, the remaining metal attached to the surface of the anodic oxidation film after filling the micropores with the metal can be removed.

Preferable examples of the surface smoothing treatment include a mechanical polishing treatment, a chemical mechanical polishing (CMP) treatment, an electrolytic polishing treatment, and an ion milling treatment.

### <Mechanical Polishing Treatment>

In the mechanical polishing treatment, the surface is rubbed with polishing cloth (for example, SiC cloth) having a grit of #800 to #1500 to adjust the thickness thereof. Next, the surface is polished with a diamond slurry having an average particle size of 1 µm to 3 µm and is further polished with a diamond slurry having an average particle size of 0.1 µm to 0.5 µm. As a result, the surface is mirror-finished.

Here, the polishing thickness of an electrode surface is preferably 0 µm to 20 µm. On the other hand, the polishing thickness of an opening surface is preferably 10 µm to 50 µm.

In addition, the rotating speed is preferably 10 rpm to 100 rpm and more preferably 20 rpm to 60 rpm.

In addition, the load is preferably 0.01 kgf/cm² to 0.1 kgf/cm² and more preferably 0.02 kgf/cm² to 0.08 kgf/cm².

### <Chemical Mechanical Polishing (CMP) Treatment>

For the CMP treatment, a CMP slurry such as PNANERLITE-7000 (manufactured by Fujimi Inc.), GPX HSC800 (manufactured by Hitachi Chemical Co., Ltd.), CL-1000 (manufactured by Asahi Glass Co., Ltd. (AGC Seimi Chemical Co., Ltd.)) can be used.

### <Electrolytic Polishing Treatment>

For the electrolytic polishing treatment, for example, various methods described in "Aluminum Handbook" 6th edition, published by Japan Aluminum Association, 2001, pp. 164-165; a method described in US2708655A; and a method described in "Journal of the Surface Finishing Society of Japan" Vol. 33 No. 3, 1986, pp. 32-38 can be used.

### <Ion Milling Treatment>

The ion milling treatment is performed when higher accuracy than in the CMP treatment and the electrolytic polishing treatment is required for polishing, and a well-known technique can be used. As an ion species, general argon ions are preferably used.

### [Other Treatments]

### <Protective Film Forming Treatment>

In the manufacturing method according to the present invention, the size of the micropores of the anodic oxidation film changes over time due to water hydration in the air. Therefore, it is preferable that a protective film forming treatment is performed before the metal filling step.

Here, regarding the protective film forming treatment, the same treatment as each treatment described in paragraphs "0133" to "0140" of JP2008-270158A can be performed.

### <Water Washing Treatment>

In the manufacturing method according to the present invention, it is preferable that water washing is performed after the completion of each of the above-described treatments. For water washing, for example, pure water, well water, or tap water can be used. In order to prevent the infiltration of the treatment liquid in the next step, a nip device may be used.

Using the manufacturing method according to the present invention including the above-described treatment steps, the metal-filled microstructure is obtained in which the inside of the through-holes derived from the micropores, which are provided in the insulating substrate formed of the anodic oxidation film of the aluminum substrate, is filled with the metal.

Specifically, using the manufacturing method according to the present invention, for example, the anisotropic conductive member described in JP2008-270158A can be obtained in a state where the residual stress is small (the amount of warping or cracking is small), the anisotropic conductive member described in JP2008-270158A being an anisotropic conductive member that is provided on an insulating substrate (the anodic oxidation film of the aluminum substrate including the micropores) in a state in which plural conductive paths, which are formed of a conductive member and are insulated from each other, penetrate the insulating substrate in a thickness direction, one end of each of the conductive paths is exposed to one surface of the insulating substrate, and the other end of each of the conductive paths is exposed to the other surface of the insulating substrate.

### Examples

The present invention will be described in detail using the following Examples. However, the present invention is not limited to Examples.

### [Example 1]

### <Preparation of Aluminum Substrate>

Molten metal was prepared using an aluminum alloy containing Si: 0.06 mass%, Fe: 0.30 mass%, Cu: 0.005 mass%, Mn: 0.001 mass%, Mg: 0.001 mass%, Zn: 0.001 mass%, Ti: 0.03 mass%, and a balance including A1 and unavoidable impurities. Next, after the molten metal treatment and filtering, an ingot having a thickness of 500 nm and a width of 1200 mm was prepared using a DC casting method

Next, the surface was cut off using a surface cutting machine to have an average thickness of 10 mm, the ingot was soaked and held at 550°C for about 5 hours. When the temperature decreased to 400°C, the ingot was rolled using a hot rolling mill to obtain a rolled sheet having a thickness of 2.7 mm.

Further, after a heat treatment was performed at 500°C using a continuous annealing machine, the rolled sheet was finished by cold rolling to have a thickness of 1.0 mm. As a result, a JIS 1050 aluminum substrate was obtained.

After adjusting the width to 1030 mm, the aluminum substrate was provided for each of the following treatments.

### <Electrolytic Polishing Treatment>

An electrolytic polishing treatment was performed on the aluminum substrate using an electrolytic polishing solution having the following composition under conditions of voltage: 25 V, liquid temperature: 65°C, and liquid flow rate: 3.0 m/min.

A carbon electrode was used as a negative electrode, and GP0110-30R (manufactured by Takasago Ltd.) was used as a power supply. In addition, the flow rate of the electrolytic solution was measured using a vortex flow monitor FLM22-10PCW (manufactured by As One Corporation).

### (Composition of Electrolytic Polishing Solution)

- 85 mass% phosphoric acid (manufactured by Wako Pure Chemical Industries, Ltd.) 660 mL
- Pure water 160 mL
- Sulfuric acid 150 mL
- Ethylene glycol 30 mL

### <Anodic Oxidation Treatment Step>

Next, an anodic oxidation treatment was performed on the aluminum substrate having undergone the electrolytic polishing treatment using a self-regulation method according to the procedure described in JP2007-204802A.

A pre-anodic oxidation treatment was performed on the aluminum substrate having undergone the electrolytic polishing treatment for 5 hours using an electrolytic solution of 0.50 mol/L of oxalic acid under conditions of voltage: 40 V, liquid temperature: 16°C, and liquid flow rate: 3.0 m/min.

Next, a film removal treatment of dipping the aluminum substrate having undergone the pre-anodic oxidation treatment in a mixed aqueous solution (liquid temperature: 50°C) of 0.2 mol/L of chromic anhydride and 0.6 mol/L of phosphoric acid for 12 hours was performed.

Next, a re-anodic oxidation treatment was performed on the aluminum substrate having undergone the electrolytic polishing treatment for 10 hours using an electrolytic solution of 0.50 mol/L of oxalic acid under conditions of voltage: 40 V, liquid temperature: 16°C, and liquid flow rate: 3.0 m/min. As a result, an anodic oxidation film having a thickness of 80 µm was obtained.

In the pre-anodic oxidation treatment and the re-anodic oxidation treatment, a stainless steel electrode was used as a negative electrode, and GP0110-30R (manufactured by Takasago Ltd.) was used as a power supply. In addition, NEOCOOL BD36 (manufactured by Yamato Scientific Co., Ltd.) was used as a cooling device, and PAIR STIRRER PS-100 (manufactured by Tokyo Rikakikai Co., LTD.) was used as a stirring heating device. Further, the flow rate of the electrolytic solution was measured using a vortex flow monitor FLM22-10PCW (manufactured by As One Corporation).

### <Barrier Layer Removal Step>

Next, using the same treatment liquid as in the anodic oxidation treatment under the same conditions as in the anodic oxidation treatment, an electrolytic treatment (electrolytic removal treatment) was performed while continuously decreasing the voltage from 40 V to 0V at a voltage decrease rate of 0.2 V/sec.

Next, an etching treatment (etching removal treatment) of dipping the anodic oxidation film in 5 mass% phosphoric acid at 30°C for 30 minutes was performed. As a result, a barrier layer present in a bottom portion of micropores of the anodic oxidation film was removed, and aluminum was exposed through the micropores.

Here, the average opening size of the micropores present in the anodic oxidation film having undergone the barrier layer removal step was 60 nm. The average opening size was calculated as the average value of opening sizes measured at 50 positions after obtaining a surface image (magnification: 50,000 times) with FE-SEM.

In addition, the average thickness of the anodic oxidation film having undergone the barrier layer removal step was 80 µm. The average thickness was calculated as the average value of thicknesses measured at 10 positions after cutting the anodic oxidation film with FIB in a thickness direction and obtaining a surface image (magnification: 50,000 times) of a cross-section thereof with FE-SEM.

In addition, the density of the micropores present in the anodic oxidation film was about 100,000,000 pieces/mm². The density of the micropores was measured and calculated using a method described in paragraphs "0168" and "0169" of JP2008-270158A.

In addition, the degree of regularity of the micropores present in the anodic oxidation film was 92%. The degree of regularity was measured and calculated using a method described in paragraphs "0024" to "0027" of JP2008-270158A after obtaining a surface image (magnification: 20,000 times) with FE-SEM.

### <Metal Filling Step (Electroplating Treatment)>

Next, an electroplating treatment was performed by using the aluminum substrate as a negative electrode and using platinum as a positive electrode.

Specifically, constant-current electrolysis was performed using a copper plating solution having the following composition. As a result, a metal-filled microstructure was manufactured in which the inside of the micropores was filled with copper.

Here, the constant-current electrolysis was performed using a plating device (manufactured by Yamamoto-MS Co., Ltd.) and a power supply (HZ-3000, manufactured by Hokuto Denko Corp.) under the following conditions after performing cyclic voltammetry in the plating solution.

### (Composition of Copper Plating Solution and Conditions)

- Copper sulfate: 100 g/L
- Sulfuric acid: 50 g/L
- Hydrochloric acid: 15 g/L
- Temperature: 25°C
- Current density: 10 A/dm²

The surface of the anodic oxidation film in which the micropores were filled with the metal was observed with FE-SEM, and whether or not 1000 micropores were sealed with the metal was determined to calculate a pore sealing ratio (the number of sealed micropores/1000). At this time the pre sealing ratio was 96%.

In addition, the anodic oxidation film in which the micropores were filled with the metal was cut using FIB in a thickness direction, a surface image (magnification: 50,000 times) of a cross-section was obtained with FE-SEM, and the inside of the micropores was observed. At this time, it was found that the inside of the sealed micropores was completely filled with the metal.

### <Substrate Removal Step>

Next, the aluminum substrate was removed by dissolution by being dipped in 20 mass% mercury chloride aqueous solution (corrosive sublimate) at 20°C for 3 hours. As a result, a metal-filled microstructure was manufactured.

### [Example 2]

A metal-filled microstructure was manufactured using the same method as in Example 1, except that a mask layer was formed in the following mask layer forming step before the anodic oxidation treatment step.

### <Mask Layer Forming Step>

A surface of the aluminum substrate was coated with a photoresist (FC-230G, manufactured by Toyobo Co., Ltd.) and was irradiated with UV rays through the mask in order to obtain a predetermined opening pattern.

Next, a non-irradiated portion was completely removed by being developed using an alkali developer, and the surface of the aluminum substrate was exposed according to the pattern.

### [Example 3]

A metal-filled microstructure was manufactured using the same method as in Example 2, except that: an adhesive layer-attached film was attached in the following film attachment step before the substrate removal step and after the metal filling step; and the adhesive layer-attached film was peeled off in the following film peeling step after the substrate removal step.

### <Film Attachment Step>

Using a laminator, an adhesive layer-attached film (E-MASK (registered trade name) HR6010 manufactured by Nitto Denko Corporation) was attached to a surface of the anodic oxidation film and a surface of the mask layer in the structure having undergone the metal filling step.

### <Film Peeling Step>

Using a device for peeling off a surface protective tape, the mask layer and the adhesive layer-attached film were peeled off from the structure having undergone the substrate removal step. As a result, a metal-filled microstructure was manufactured.

### [Example 4]

A metal-filled microstructure was manufactured using the same method as in Example 3, except that a surface of the anodic oxidation film including the micropores filled with the metal and a surface of the mask layer were polished in the following polishing step (mechanical polishing treatment) before the film attachment step and after the metal filling step. The thickness of the manufactured metal-filled microstructure was 65 µm.

### <Polishing Step (Mechanical Polishing Treatment)>

A ceramic jig (manufactured by Kemet Japan Co., Ltd.) was used as a sample stage used in the polishing step, and ALCO wax (manufactured by Nikka Seiko Co., Ltd.) was used as a material to be attached to the sample stage. In addition, DP suspensions P-6 µm, 3 µm, 1 µm, and 1/4 µm (manufactured by Marumoto Struers K.K.) were sequentially used as abrasives.

### [Example 5]

A metal-filled microstructure was manufactured using the same method as in Example 4, except that the surface, in contact with the aluminum substrate, of the anodic oxidation film was polished in the surface smoothing step, in which the same mechanical polishing treatment as in the polishing step was performed, before the film peeling step and after the substrate removal step. The thickness of the manufactured metal-filled microstructure was 50 µm.

### [Example 6]

A metal-filled microstructure was manufactured using the same method as in Example 1, except that the metal filling step was performed using Ni according to the following method.

### <Metal Filling Step (Electroplating Treatment)>

An electroplating treatment was performed by using the aluminum substrate as a negative electrode and using platinum as a positive electrode. During the metal filling, constant-current electrolysis (5 A/dm²) was performed by using a mixed solution containing nickel sulfate/nickel chloride/boric acid=300/60/40 (g/L), which was held at 50°C, as an electrolytic solution.

### [Example 7]

A metal-filled microstructure was manufactured using the same method as in Example 1, except that the barrier layer removal step was performed using the following method, that is, the etching removal treatment was not performed in the barrier layer removal step.

### <Barrier Layer Removal Step>

Next, using the same treatment liquid as in the anodic oxidation treatment under the same conditions as in the anodic oxidation treatment, an electrolytic treatment (electrolytic removal treatment) was performed while continuously decreasing the voltage from 40 V to 0V at a voltage decrease rate of 0.2 V/sec.

### [Comparative Example 1]

A metal-filled microstructure was manufactured using the same method as in Example 1, except that the step performed after the anodic oxidation step was changed to the following step.

### <Penetration Treatment Step>

Next (after the anodic oxidation treatment step), the aluminum substrate was dissolved by being dipped in 20 mass% mercury chloride aqueous solution (corrosive sublimate) at 20°C for 3 hours. As a result, a metal-filled microstructure was manufactured. Further, the bottom portion (barrier layer) of the anodic oxidation film was removed by being dipped in 5 mass% phosphoric acid at 30°C for 30 minutes. As a result, a structure formed of the anodic oxidation film including micropores was manufactured.

### <Heat Treatment Step>

Next, a heat treatment was performed on the structure obtained as described above at a temperature of 400°C for 1 hour.

### <Electrode Film Forming Treatment>

Next, an electrode film was formed on a single surface of the structure having under gone the heat treatment.

That is, 0.7 g/L of chloroauric acid aqueous solution was applied to the single surface, was dried at 140°C for 1 minute, and was fired at 500°C for 1 hour to prepare gold plating nuclei.

Next, the surface was dipped in PRECIOUSFAB ACG 2000 base solution/reducer solution as an electroless plating solution (manufactured by Electroplating Engineers of Japan Ltd.) at 50°C for 1 hour to form an electrode film having no voids.

### <Metal Filling Step>

Next, the inside of the micropores of the structure were filled with the metal by performing the same electroplating treatment as in Example 1.

### <Polishing Step and Surface Smoothing Step>

Next, 15 µm regions of both surfaces were polished by performing the same mechanical polishing treatment as in the polishing step of Example 4. As a result, a metal-filled microstructure having a thickness of 50 µm was obtained.

### [Comparative Example 2]

A metal-filled microstructure was manufactured using the same method as in Example 1, except that the barrier layer removal step (the electrolytic removal treatment and the etching removal treatment) was not performed.

Here, as in Example 1, after the metal filling step, the surface of the anodic oxidation film in which the micropores were filled with the metal was observed with FE-SEM, and whether or not 1000 micropores were sealed with the metal was determined to calculate a pore sealing ratio (the number of sealed micropores/1000). At this time the pre sealing ratio was 1% or lower.

In addition, the anodic oxidation film in which the micropores were filled with the metal was cut using FIB in a thickness direction, a surface image (magnification: 50,000 times) of a cross-section was obtained with FE-SEM, and an internal region of the micropores near the barrier layer was observed. At this time, it was found that the metal was not deposited on substantially all the micropores and metal filling was insufficient.

It was found from the above result that, with the manufacturing method of Comparative Example 2, it is difficult to fill the micropores with the metal.

### [Evaluation]

Regarding each of the metal-filled microstructures manufactured in Examples 1 to 7 and Comparative Example 1, the residual stress and the number of cracks were investigated using the following method. The results are shown in Table 1 below. In Table 1 below, the evaluation results of Comparative Example 2 are represented by "-".

### <Residual Stress>

Using an X-ray diffractometer (XRD, D8 Discover with GADDS, manufactured by Bruker BioSpin K.K.), the residual stress was calculated according to the 2θ·sin²ψ method.

The measurement was performed under conditions of voltage/current: 45 kV/110 mA, X-ray wavelength: CrKα ray, X-ray irradiation width: 500 µm, and evaluation crystal plane: Cu (311) plane or Ni (311) plane.

### <Number of Cracks>

Regarding the number of cracks, 10 samples were prepared for each of the metal-filled microstructures, and an internal structure of the metal-filled microstructure was observed using a microfocus X-ray CT System (SMX-160CTS, manufactured by Shimadzu Corporation). As a result, the number of cracks in each of the samples was obtained, and the average number of cracks was calculated.

**[Table 1]**

| Table 1 | Barrier Layer Removal Step | | Metal Filling Step (Filling Metal Species) | Mask Layer Forming Step | Film Attachment Step (Film Peeling Step) | Polishing Step | Surface Smoothing Step | Metal-Filled Microstructure | | |
|---|---|---|---|---|---|---|---|---|---|---|
| | Electrolytic Removal Treatment | Etching Removal Treatment | | | | | | Thickness [µm] | Residual Stress [MPa] | Number of Cracks |
| Example 1 | Performed | Performed | Cu | Not Performed | Not Performed | Not Performed | Not Performed | 80 | 30 | 2 |
| Example 2 | Performed | Performed | Cu | Performed | Not Performed | Not Performed | Not Performed | 80 | 5 | 0 |
| Example 3 | Performed | Performed | Cu | Performed | Performed | Not Performed | Not Performed | 80 | 5 | 0 |
| Example 4 | Performed | Performed | Cu | Performed | Performed | Performed | Not Performed | 65 | 7 | 0 |
| Example 5 | Performed | Performed | Cu | Performed | Performed | Performed | Performed | 50 | 10 | 0 |
| Example 6 | Performed | Performed | Ni | Not Performed | Not Performed | Not Performed | Not Performed | 80 | 28 | 2 |
| Example 7 | Performed | Not Performed | Cu | Not Performed | Not Performed | Not Performed | Not Performed | 80 | 60 | 5 |
| Comparative Example 1 | Not Performed (Penetration Treatment) | | Cu | - | - | Performed | Performed | 50 | 210 | 15 |
| Comparative Example 2 | Not Performed | | Cu | Not Performed | Not Performed | Not Performed | Not Performed | 80 | - | - |

### It was found from the results of Table 1 that, when metal filling is performed after removing the substrate and forming the through-holes from the micropores, the residual stress was high, and the number of cracks was large (Comparative Example 1).

On the other hand, it was found that, when metal filling was performed using the aluminum substrate as an electrode after removing the barrier layer, the residual stress was low, and the number of cracks was small (Examples 1 to 7).

In particular, it was found from a comparison between Example I and Example 2 that the residual stress was extremely low when the inside of micropores was filled with metal in a state where not only the lower portion of the anodic oxidation film but also the periphery of the anodic oxidation film were surrounded by the aluminum substrate by forming the mask layer before the anodic oxidation treatment.

In addition, it was found from a comparison between Example 1 and Example 7 that the residual stress was further reduced and the number of cracks was further reduced by performing not only the electrolytic removal treatment but also the etching removal treatment in the barrier layer removal step.

### Explanation of References

1: aluminum substrate
2: micropore
3: barrier layer
4: anodic oxidation film
5: metal
6: mask layer
7: adhesive layer-attached film
10, 20: metal-filled microstructure

## Claims

1. A method for manufacturing a metal-filled microstructure, the method comprising:
an anodic oxidation treatment step of anodically oxidizing a single surface of an aluminum substrate to form an anodic oxidation film on the single surface of the aluminum substrate, the anodic oxidation film including micropores, which are present in a thickness direction, and a barrier layer which is present in a bottom portion of the micropores;
a barrier layer removal step of removing the barrier layer of the anodic oxidation film after the anodic oxidation treatment step;
a metal filling step of filling the inside of the micropores with metal through an electroplating treatment after the barrier layer removal step; and
a substrate removal step of removing the aluminum substrate to obtain a metal-filled microstructure after the metal filling step.

2. The method for manufacturing a metal-filled microstructure according to claim 1,
wherein in the barrier layer removal step, the barrier layer is electrochemically dissolved at a potential lower than that in the anodic oxidation treatment of the anodic oxidation treatment step.

3. The method for manufacturing a metal-filled microstructure according to claim 1,
wherein in the barrier layer removal step, the barrier layer is removed by etching.

4. The method for manufacturing a metal-filled microstructure according to claim 1,
wherein in the barrier layer removal step, the barrier layer is removed by etching after being electrochemically dissolved at a potential lower than that in the anodic oxidation treatment of the anodic oxidation treatment step.

5. The method for manufacturing a metal-filled microstructure according to any one of claims 1 to 4, further comprising:
a mask layer forming step of forming a mask layer having a desired shape in advance on a single surface of the aluminum substrate to be anodically oxidized before the anodic oxidation treatment step.

6. The method for manufacturing a metal-filled microstructure according to any one of claims 1 to 5, further comprising:
a film attachment step of attaching a peelable adhesive layer-attached film to a surface of the anodic oxidation film including the micropores filled with the metal before the substrate removal step and after the metal filling step; and
a film peeling step of peeling off the adhesive layer-attached film after the substrate removal step.

7. The method for manufacturing a metal-filled microstructure according to claim 5 or 6, further comprising:
a polishing step of polishing a surface of the anodic oxidation film including the micropores filled with the metal and a surface of the mask layer to remove at least the mask layer after the metal filling step.

8. The method for manufacturing a metal-filled microstructure according to any one of claims 1 to 7, further comprising:
a surface smoothing step of smoothing the surface, in contact with the aluminum substrate, of the anodic oxidation film including the micropores filled with the metal after the substrate removal step.
